# EUROPEAN PATENT APPLICATION

(11) **EP 4 474 843 A1**
(43) Date of publication of application: **11.12.2024**
(21) Application number: 22923926.4
(22) Date of filing: 31.01.2022
(51) Int. Cl.: G01R 33/02, G01R 33/06

(54) **MAGNETIC SENSOR**

(71) Applicant: TDK Corporation, Tokyo 103-6128 (JP)
(72) Inventor: KASAJIMA, Tamon, Tokyo 103-6128 (JP); KAMENO, Makoto, Binan, Laguna (PH); HARAKAWA, Osamu, Binan, Laguna (PH)
(74) Representative: Epping - Hermann - Fischer
(86) International application number: PCT/JP2022/003578
(87) International publication number: WO 2023/145063

(57) **Abstract**

To reduce the influence of disturbance noise in a magnetic sensor provided with an external magnetic body around which a compensation coil is wound. A magnetic sensor 100 includes an external magnetic body 30 that collects a magnetic field to be detected in a magnetosensitive element and a compensation coil C. The compensation coil C includes a solenoid part C0 wound around the external magnetic body 30 and lead-out parts C1 and C2 that connect both ends of the solenoid part C0 respectively to connection pins P1 and P2. The lead-out part C2 passes through the inner diameter area of the solenoid part C0 to be connected to the connection pin P2. This makes the second lead-out part unlikely to act as an antenna, which can reduce the influence of disturbance noise.

## Description

### [Technical Field]

The present invention relates to a magnetic sensor and, more particularly, to a magnetic sensor provided with an external magnetic body for collecting magnetic flux in a magnetosensitive element and a compensation coil.

### [Background Art]

Patent Document 1 discloses a magnetic sensor provided with an external magnetic body for collecting magnetic flux in a magnetosensitive element and a compensation coil. More specifically, the magnetic sensor described in Patent Document 1 is provided with a magnetosensitive element integrated in a sensor chip, an external magnetic body, and a compensation coil wound around the external magnetic body. With this configuration, a magnetic field collected by the external magnetic body is applied to the magnetosensitive element, and the magnetic field applied to the magnetosensitive element is cancelled by the compensation coil, whereby closed-loop control is achieved. This always maintains the magnetic field to be applied to the magnetosensitive element in a zero state, preventing offset caused by a temperature change, which allows accurate magnetic field measurement.

### [Citation List]

### [Patent Document]

[Patent Document 1] International Publication WO 2021/100252

### [Disclosure of the Invention]

### [Problem to be Solved by the Invention]

However, when the compensation coil is wound around a bar-like external magnetic body, a lead-out part of the compensation coil acts as an antenna, disadvantageously making the magnetic sensor likely to be influenced by disturbance noise.

It is therefore an object of the present invention to reduce influence of disturbance noise in a magnetic sensor provided with an external magnetic body around which a compensation coil is wound.

### [Means for Solving the Problem]

A magnetic sensor according to the present invention includes a magnetosensitive element, an external magnetic body collecting a magnetic field to be detected in the magnetosensitive element, and a compensation coil connected to first and second terminal electrodes. The compensation coil includes a solenoid part wound around the external magnetic body, a first lead-out part positioned between one end of the solenoid part and the first terminal electrode and a second lead-out part positioned between the other end of the solenoid part and the second terminal electrode. The one end of the solenoid part is positioned on one side of the external magnetic body in the axial direction, and the other end thereof is positioned on the other side thereof in the axial direction. The first and second terminal electrodes are positioned on one side in the axial direction, and the second lead-out part passes through the inner diameter area of the solenoid part so as to be connected to the second terminal electrode.

According to the present invention, the second lead-out part whose wiring distance is long is accommodated in the inner diameter area of the solenoid part and is thus made unlikely to act as an antenna. This can reduce the influence of disturbance noise.

The magnetic sensor according to the present invention may further include a molded member having a bobbin positioned between the external magnetic body and the solenoid part. The solenoid part may be wound around the bobbin, and the second lead-out part may be positioned between the bobbin and the solenoid part. This can prevent contact between the compensation coil and the external magnetic body.

In the present invention, the first and second terminal electrodes may be formed as first and second connection pins, respectively, and the molded member may further include a retaining part for retaining the first and connection second pins. This can reduce the number of components and can fix the positional relation between the first and second connection pins and the bobbin.

In the present invention, the first and second connection pins may protrude in a predetermined direction perpendicular to the axial direction of the external magnetic body from the retaining part, and the first and second lead-out parts may be fixed to a position closer to the leading ends of the first and second connection pins than to the retaining part. This facilitates connection work to connect the first and second connection pins and the compensation coil using a solder bath.

In the present invention, the first and second connection pins each may have a first positioning part positioning the position of each of the first and second lead-out parts in the predetermined direction. This can fix the position of each of the first and second lead-out parts in the predetermined direction.

In the present invention, the molded member may have a second positioning part positioned between the bobbin and the retaining part and positioning the first and second lead-out parts in the predetermined direction. This further facilitates connection work to connect the first and second connection pins and the compensation coil using a solder bath.

In the present invention, the external magnetic body, compensation coil, and first and second connection pins may be fixed to the molded member to constitute a magnetism collecting module, and a sensor chip including the magnetosensitive element and the magnetism collecting module may be mounted on the same plane of the substrate. Using the thus configured magnetism collecting module facilitates assembly work.

In the present invention, the external magnetic body may have a wide part and a narrow part whose cross section perpendicular to the axial direction is smaller than that of the wide part, the bobbin may house therein the narrow part of the external magnetic body, the retaining part may house therein the wide part of the external magnetic body, an opening may be formed in the bottom surface of each of the bobbin and retaining part that faces the substrate, the wide part of the external magnetic body may protrude from the opening of the retaining part, the narrow part of the external magnetic body may not protrude from the opening of the bobbin, and the wide part protruding from the opening of the retaining part may be fixed to the substrate. This can accurately position the external magnetic body onto the substrate and prevent contact between the external magnetic body and the compensation coil.

### [Advantageous Effects of the Invention]

As described above, according to the present invention, it is possible to reduce the influence of disturbance noise in a magnetic sensor provided with an external magnetic body around which a compensation coil is wound.

### [Brief Description of the Drawings]

[FIG. 1]

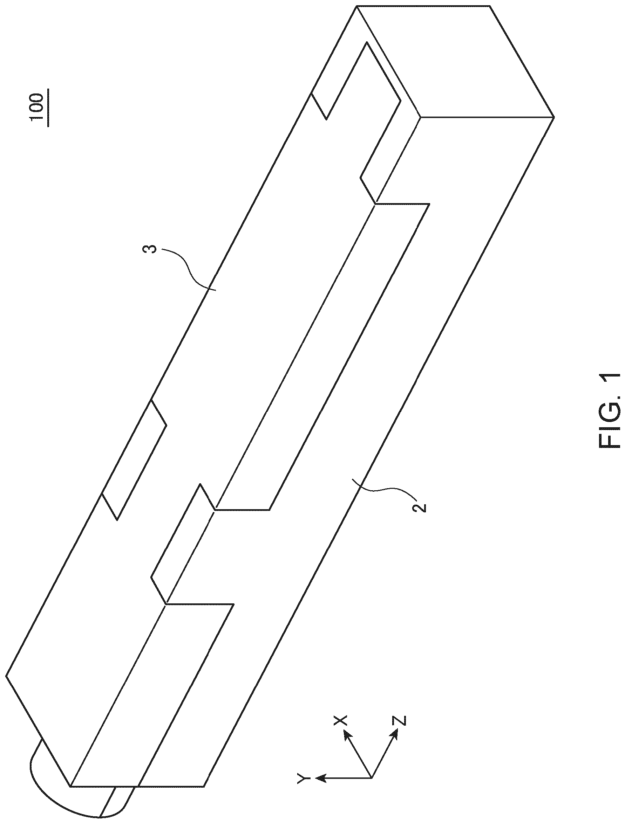

   FIG. 1 is a schematic perspective view illustrating the outer appearance of a magnetic sensor 100 according to an embodiment of the present invention.
[FIG. 2]

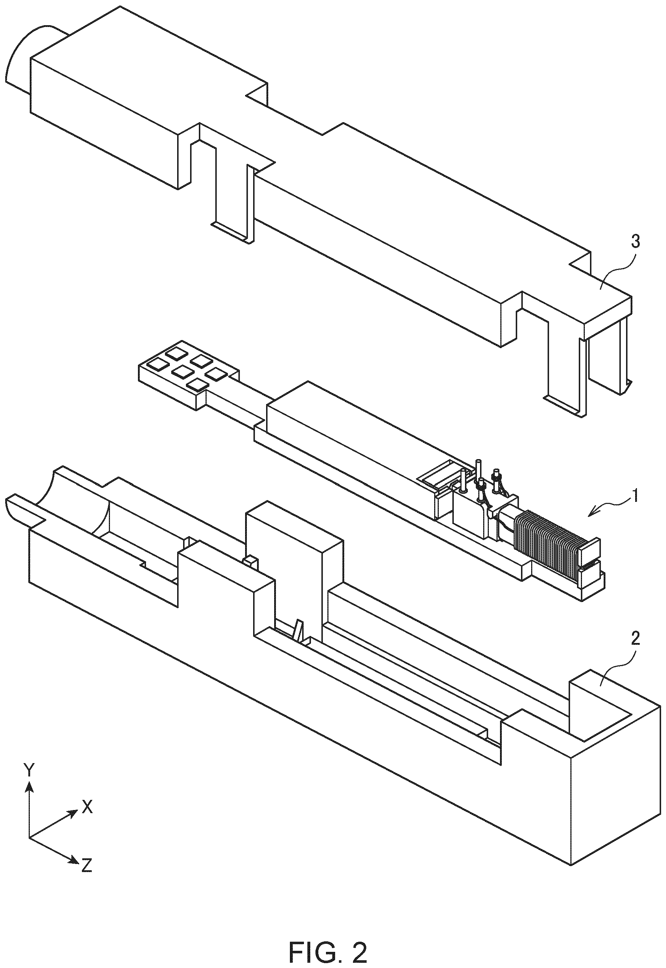

   FIG. 2 is a schematic exploded perspective view of the magnetic sensor 100.
[FIG. 3]

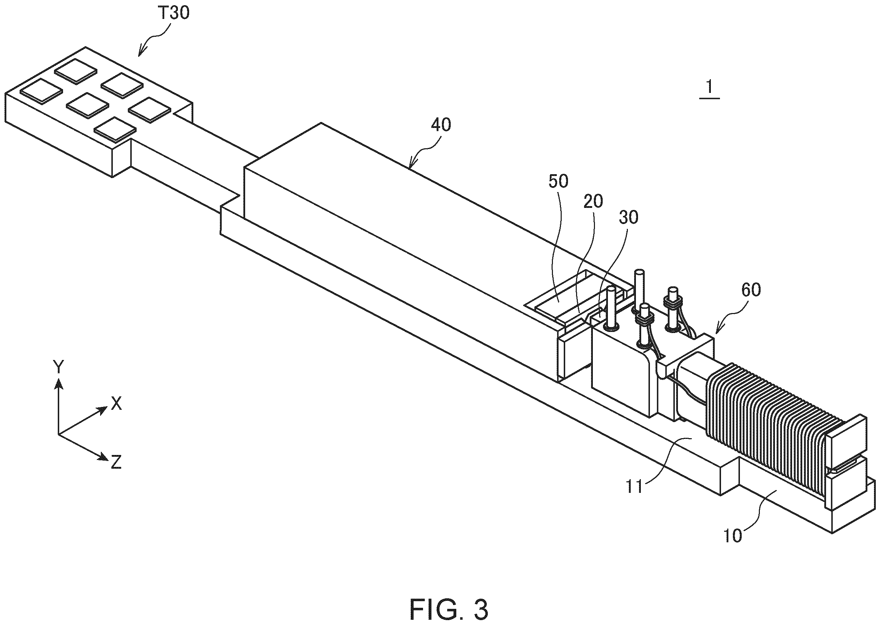

   FIG. 3 is a schematic perspective view illustrating the outer appearance of the magnetic sensor module 1.
[FIG. 4]

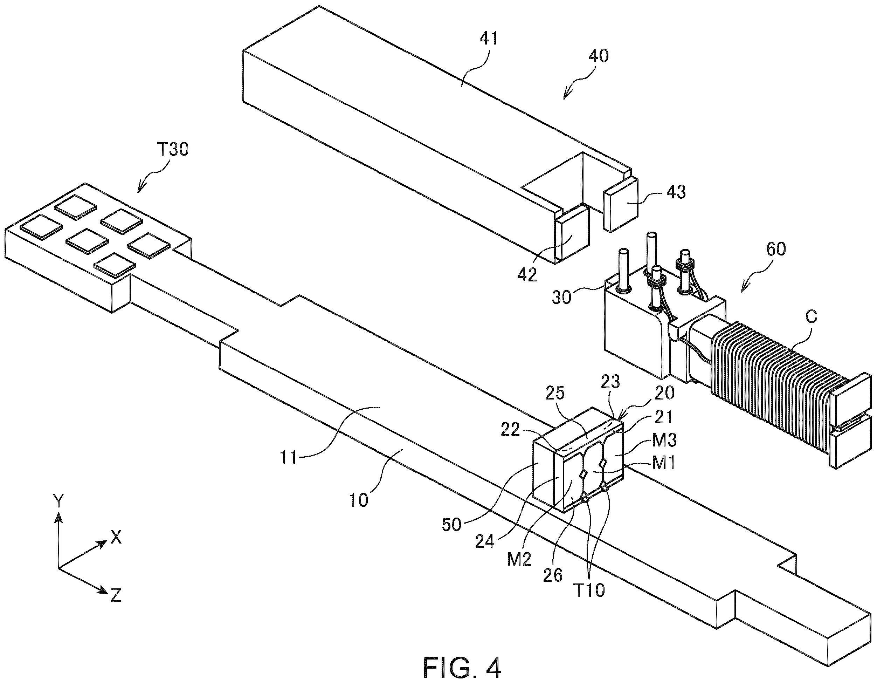

   FIG. 4 is a schematic exploded perspective view of the magnetic sensor module 1.
[FIG. 5]

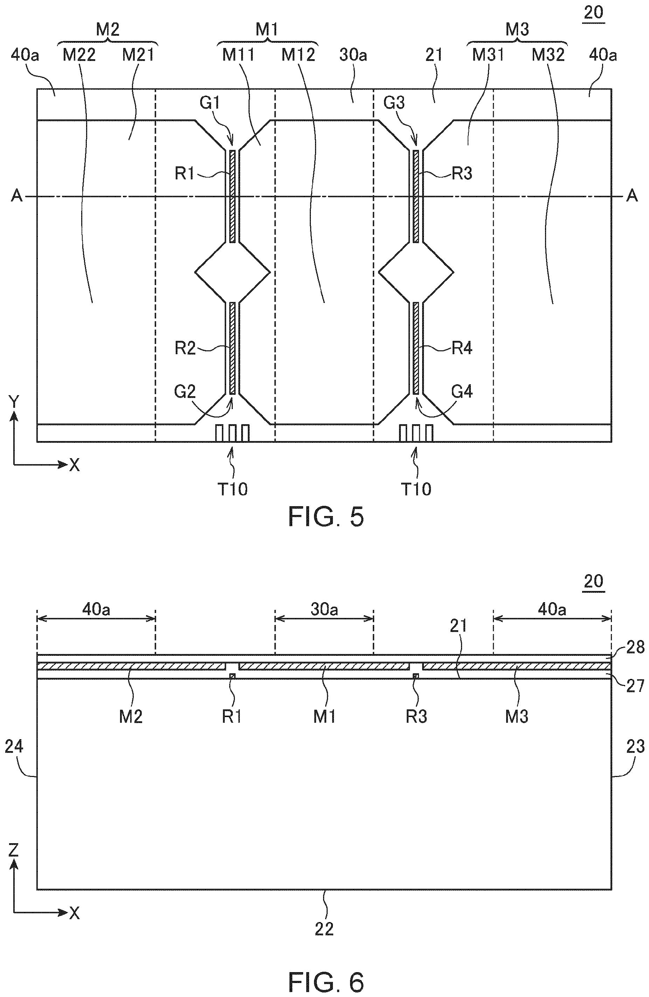

   FIG. 5 is a schematic plan view of the sensor chip 20.
[FIG. 6]
   FIG. 6 is a schematic cross-sectional view taken along the line A-A in FIG. 5.
[FIG. 7]

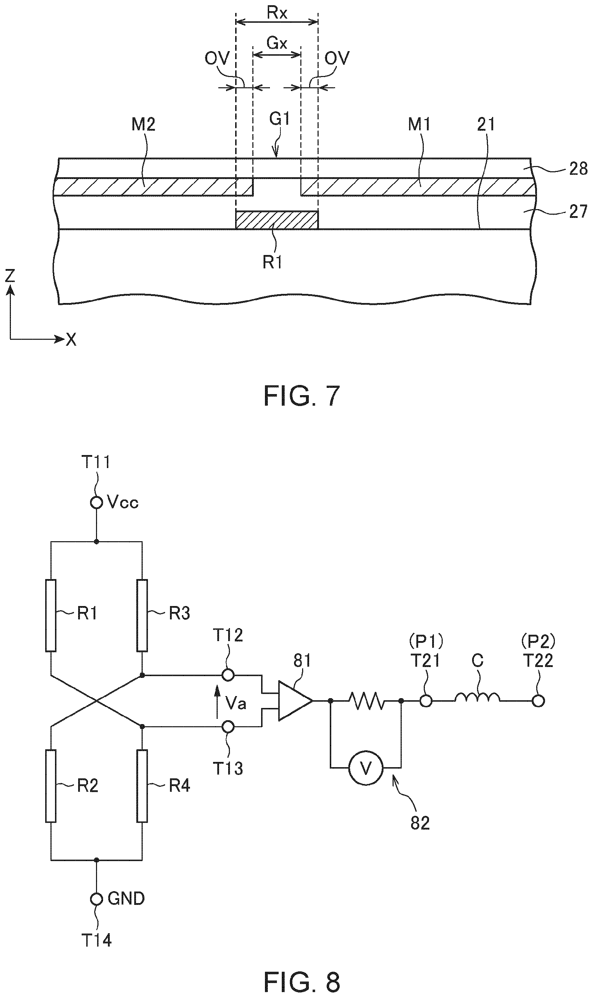

   FIG. 7 is a schematic cross-sectional view for explaining an example in which the magnetic layer and the magnetosensitive element overlap.
[FIG. 8]
   FIG. 8 is a circuit diagram for explaining the connection relation between the magnetosensitive elements R1 to R4 and the compensation coil C.
[FIG. 9]

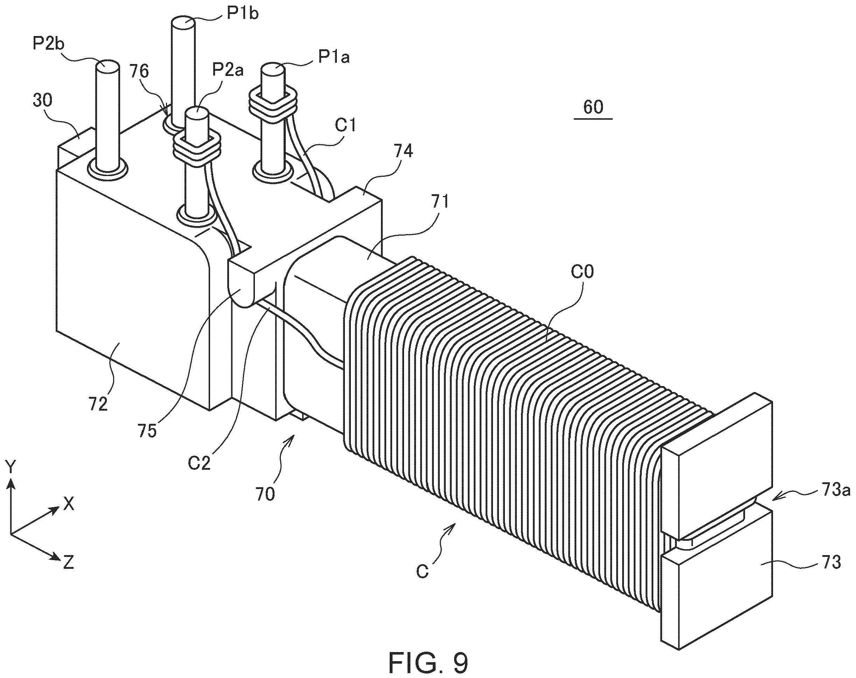

   FIG. 9 is a schematic perspective view for explaining the structure of the magnetism collecting module 60.
[FIG. 10]

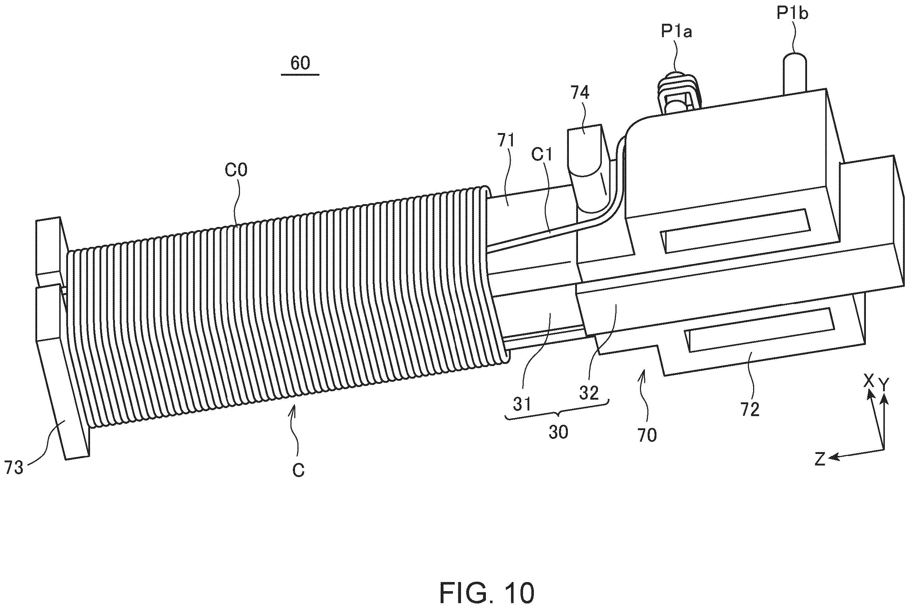

   FIG. 10 is a schematic perspective view for explaining the structure of the magnetism collecting module 60.
[FIG. 11]

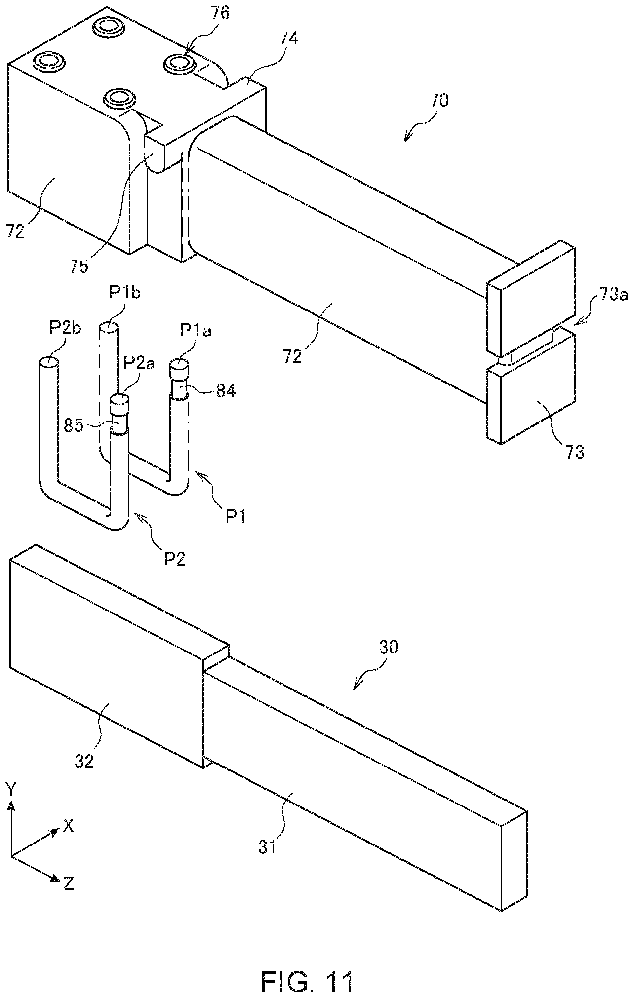

   FIG. 11 is a schematic exploded perspective view of the magnetism collecting module 60 in a state where the compensation coil C is removed.
[FIG. 12]

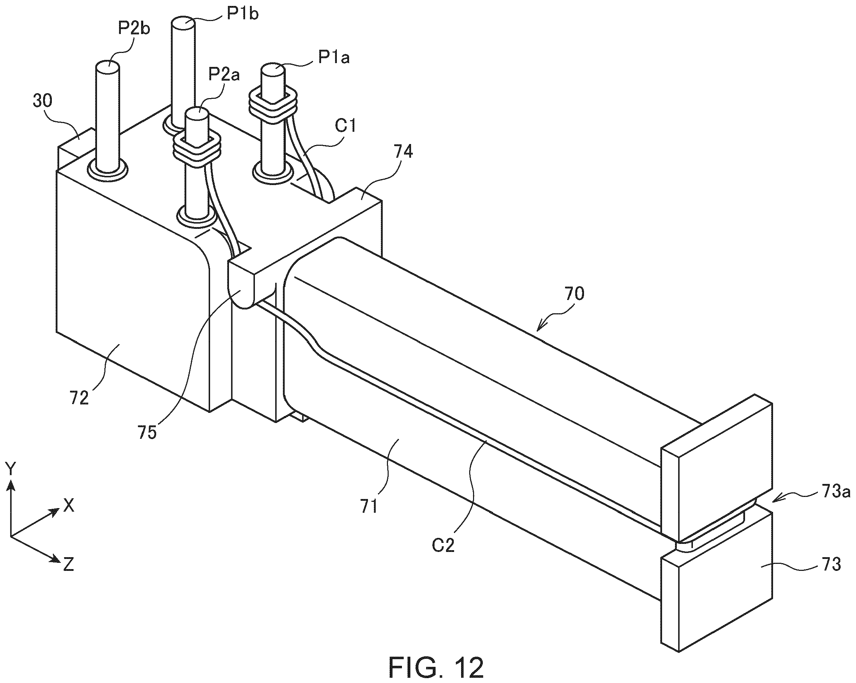

   FIG. 12 is a schematic perspective view illustrating a state where the solenoid part C0 of the compensation coil C is removed from the magnetism collecting module 60.
[FIG. 13]

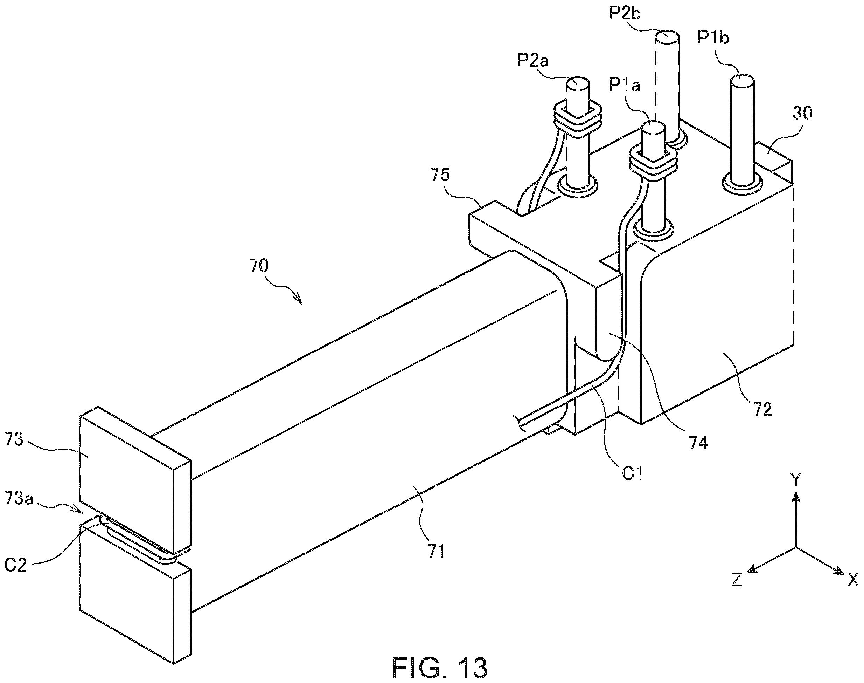

   FIG. 13 is a schematic perspective view illustrating a state where the solenoid part C0 of the compensation coil C is removed from the magnetism collecting module 60.
[FIG. 14]

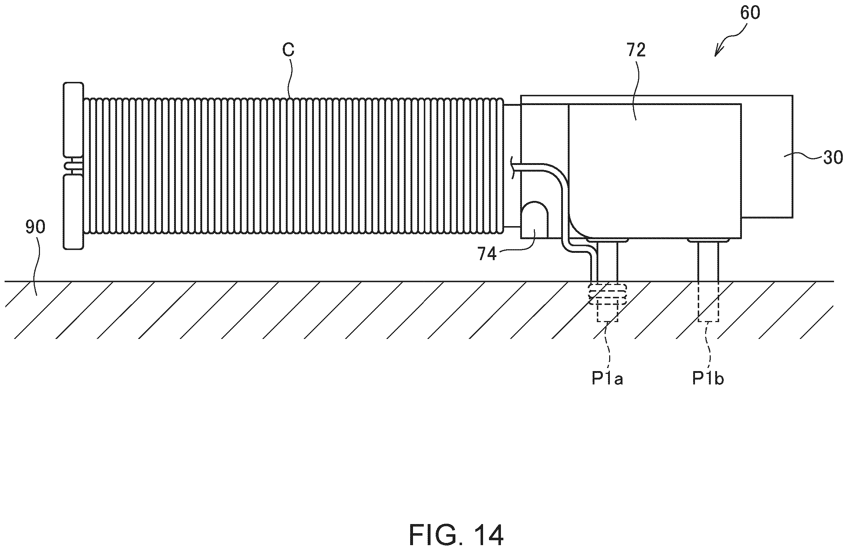

   FIG. 14 is a schematic diagram for explaining a method of fixing one end and the other end of the compensation coil C to the connection pins P1 and P2.
[FIG. 15]

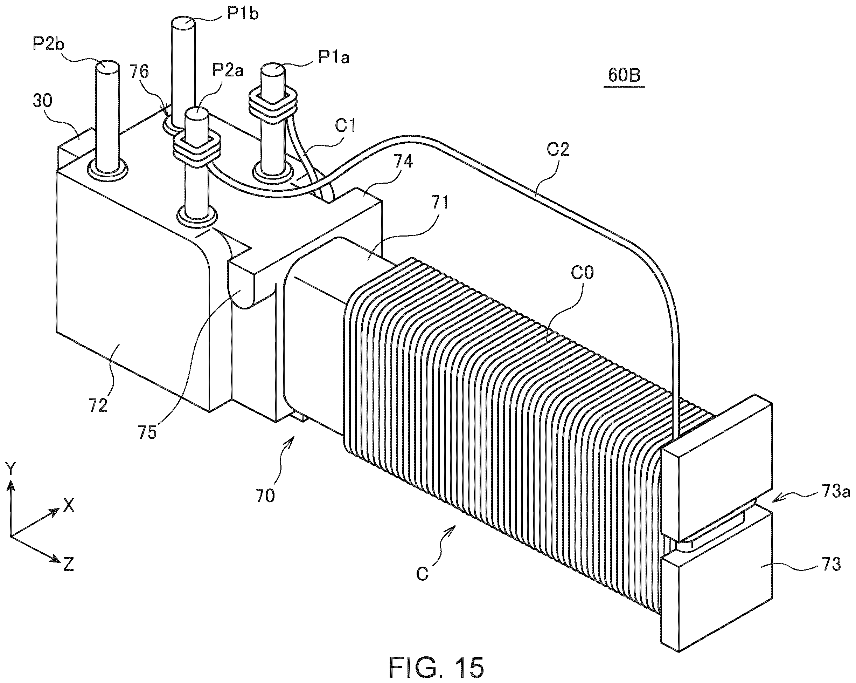

   FIG. 15 is a schematic perspective view illustrating the configuration of a magnetism collecting module 60B according to a comparative example.
[FIG. 16]

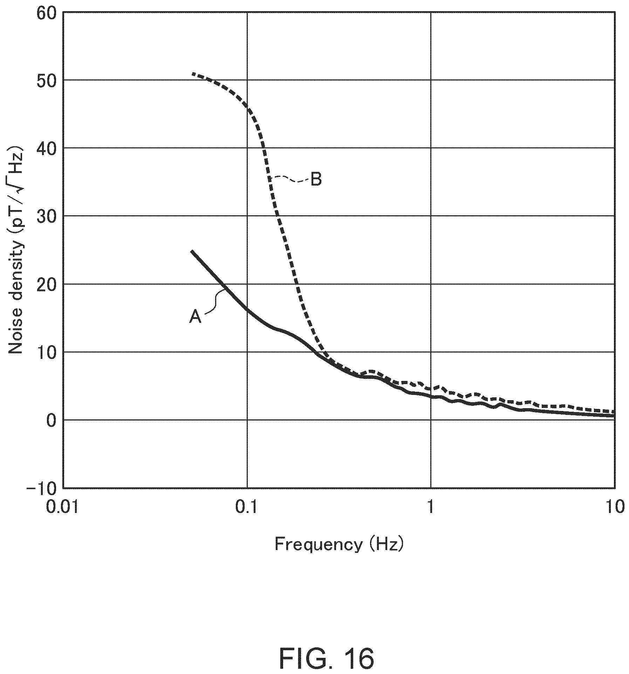

   FIG. 16 is a graph illustrating the frequency characteristics of noise density.

### [Mode for Carrying Out the Invention]

Hereinafter, preferred embodiments of the present invention will be described in detail with reference to the accompanying drawings.

FIG. 1 is a schematic perspective view illustrating the outer appearance of a magnetic sensor 100 according to an embodiment of the present invention. FIG. 2 is a schematic exploded perspective view of the magnetic sensor 100.

As illustrated in FIGS. 1 and 2, the magnetic sensor 100 according to the present embodiment includes a magnetic sensor module 1 as a main body part and lower and upper cases 2 and 3 housing therein the magnetic sensor module 1. The lower and upper cases 2 and 3 are made of a non-magnetic insulating material, such as resin, and fitted to each other in the Y-direction to form an internal space, in which the magnetic sensor module 1 is housed. The magnetic sensor 100 has a bar-like body elongated in the Z-direction, and the end portion thereof on the positive Z-direction side constitutes a sensor head. A not-shown wiring connected to the magnetic sensor module 1 is led out from the end potion on the negative Z-direction side.

FIG. 3 is a schematic perspective view illustrating the outer appearance of the magnetic sensor module 1. FIG. 4 is a schematic exploded perspective view of the magnetic sensor module 1.

As illustrated in FIGS. 3 and 4, the magnetic sensor module 1 includes a substrate 10, a sensor chip 20, an external magnetic body 40, and an auxiliary chip 50 which are mounted on a surface 11 constituting the XZ plane of the substrate 10, and a magnetism collecting module 60 including an external magnetic body 30. The sensor chip 20 has an element formation surface 21 and a back surface 22 which constitute the XY plane, side surfaces 23 and 24 constituting the YZ plane, and side surfaces 25 and 26 constituting the XZ plane and is mounted on the substrate 10 such that the side surface 26 faces the surface 11 of the substrate 10. There are formed on the element formation surface 21 of the sensor chip 20, a magnetosensitive element (to be described later) and magnetic layers M1 to M3 (to be described later). As described above, in the present embodiment, the surface 11 of the substrate 10 and the element formation surface 21 of the sensor chip 20 are perpendicular to each other; however, they need not be completely perpendicular to each other, but the angle formed therebetween may deviate from the perpendicularity.

The external magnetic bodies 30 and 40 act to collect magnetic flux in the sensor chip 20 and are made of a high-permeability material, such as ferrite. The external magnetic body 30 has a bar-like body elongated in the Z-direction and is positioned at substantially the X-direction center of the element formation surface 21 so as to partly cover the magnetic layer M1. The external magnetic body 40 is positioned on the side opposite to the external magnetic body 30 with respect to the sensor chip 20. The external magnetic body 40 has a bar-like part 41 elongated in the Z-direction and covering the back surface 22 of the sensor chip 20 and overhang parts 42 and 43 protruding in the Z-direction to the element formation surface 21 side from the bar-like part 41 so as to respectively cover the side surfaces 23 and 24 of the sensor chip 20 and extending in the X-direction so as to partly cover the magnetic layers M2 and M3. With this configuration, a magnetic field in the Z-direction is selectively collected, and the collected magnetic field is applied to the sensor chip 20.

The auxiliary chip 50 acts to enhance the strength of the sensor chip 20 and is stuck to the back surface 22 of the sensor chip 20 using an adhesive or the like. The auxiliary chip 50 may be made of the same material as the material of the sensor chip 20. Although not particularly limited, the thickness of the auxiliary chip 50 in the Z-direction is larger than the thickness of the sensor chip 20 in the Z-direction, whereby the mechanical strength of the sensor chip 20 is sufficiently enhanced.

The magnetism collecting module 60 includes a molded member 70 housing the external magnetic body 30 and a compensation coil C wound around the molded member 70. The number of turns of a wire constituting the compensation coil C is not particularly limited and may be set to a value required to generate a target cancelling magnetic field. The molded member 70 is made of a non-magnetic insulating member, such as resin. The structure and role of the molded member 70 will be described later.

FIG. 5 is a schematic plan view of the sensor chip 20, and FIG. 6 is a schematic cross-sectional view taken along the line A-A in FIG. 5.

As illustrated in FIGS. 5 and 6, four magnetosensitive elements R1 to R4 are formed on the element formation surface 21 of the sensor chip 20. The magnetosensitive elements R1 to R4 are not particularly limited in type as long as they are elements whose electric resistance varies depending on the direction of magnetic flux and may be, for example, an MR element. The fixed magnetization directions of the magnetosensitive elements R1 to R4 are the same direction (for example, positive X-direction). The magnetosensitive elements R1 to R4 are covered with an insulating layer 27, on the surface of which magnetic layers M1 to M3 made of permalloy are formed. The magnetic layers M1 to M3 are covered with an insulating layer 28. Assume that parts of the respective magnetic layers M1 to M3 that are positioned at one side (upper side in FIG. 5) in the Y-direction are defined as magnetic layers M11, M21, and M31, and parts of the respective magnetic layers M1 to M3 that are positioned at the other side (lower side in FIG. 5) in the Y-direction are defined as magnetic layers M12, M22, and M32. In this case, in a plan view (as viewed in the Z-direction), the magnetosensitive element R1 is positioned between the magnetic layers M11 and M21, the magnetosensitive element R2 is positioned between the magnetic layers M12 and M22, the magnetosensitive element R3 is positioned between the magnetic layers M11 and M31, and the magnetosensitive element R4 is positioned between the magnetic layers M12 and M32. With this configuration, magnetic fields passing through respective magnetic gaps G1 to G4 are applied respectively to the magnetosensitive elements R1 to R4.

However, in the present invention, the magnetosensitive elements R1 to R4 each need not be positioned between two corresponding magnetic layers in a plan view but may each be disposed at least in the vicinity of the magnetic gaps G1 to G4 constituted by two magnetic layers, that is, on a magnetic path formed by the magnetic gaps G1 to G4. Further, the width of each of the magnetic gaps G1 to G4 need not be larger than the width of each of the magnetosensitive elements R1 to R4 and may be smaller than the width of each of the magnetosensitive elements R1 to R4. In the example illustrated in FIG. 7, a width Gx of the magnetic gap G1 in the X-direction is smaller than a width Rx of the magnetosensitive element R1 in the X-direction, and thus the magnetic layers M1 and M2 and the magnetosensitive element R1 have an overlap OV in the Z-direction. The positional relation between the magnetic gaps G1 to G4 and the magnetosensitive elements R1 to R4 may be that illustrated in FIG. 7.

In FIGS. 5 and 6, the area designated by a reference numeral 30a is an area covered with the external magnetic body 30, and the areas designated by reference numerals 40a are areas covered with the external magnetic body 40. As illustrated in FIGS. 5 and 6, the external magnetic body 30 covers the magnetic layer M1, and the external magnetic body 40 covers the magnetic layers M2 and M3. To efficiently apply a magnetic field collected by the external magnetic body 30 to the magnetosensitive elements R1 to R4, the XY end face of the external magnetic body 30 facing the element formation surface 21 preferably directly contacts the insulating layer 28 on the magnetic layer M1 directly or through an adhesive.

FIG. 8 is a circuit diagram for explaining the connection relation between the magnetosensitive elements R1 to R4 and the compensation coil C.

As illustrated in FIG. 8, the magnetosensitive element R1 is connected between terminal electrodes T11 and T13, the magnetosensitive element R2 is connected between terminal electrodes T12 and T14, the magnetosensitive element R3 is connected between terminal electrodes T11 and T12, and the magnetosensitive element R4 is connected between terminal electrodes T13 and T14. The terminal electrodes T11 to T14 constitute a terminal electrode group T10 illustrated in FIG. 4. The terminal electrode group T10 is provided on the sensor chip 20 and connected to a terminal electrode group T30 illustrated in FIGS. 3 and 4 through a not-shown wiring formed on the substrate 10. The terminal electrode T11 is applied with a power supply potential Vcc, and the terminal electrode T14 is applied with a ground potential GND. Since the magnetosensitive elements R1 to R4 have the same fixed magnetization direction, a difference occurs between a resistance change in the magnetosensitive elements R1 and R2 which are positioned on one side as viewed from the external magnetic body 30 and a resistance change in the magnetosensitive elements R3 and R4 which are positioned on the other side as viewed from the external magnetic body 30. As a result, the magnetosensitive elements R1 to R4 constitute a differential bridge circuit, and a change in the electrical resistance of the magnetosensitive elements R1 to R4 according to a magnetic flux density appears in the terminal electrodes T12 and T13 as a differential signal Va.

The differential signal Va output from the terminal electrodes T12 and T13 is input to a differential amplifier 81 provided on the substrate 10 or sensor chip 20. An output signal from the differential amplifier 81 is fed back to a terminal electrode T21. As illustrated in FIG. 8, the compensation coil C is connected between the terminal electrode T21 and a terminal electrode T22, whereby the compensation coil C generates a cancelling magnetic field in accordance with the output signal from the differential amplifier 81. The terminal electrodes T21 and T22 are connected respectively to connection pins P1 and P2 retained by the molded member 70. When the differential signal Va output in accordance with a change in the electric resistance of the magnetosensitive elements R1 to R4 according to the magnetic flux density of a magnetic field to be detected appears in the terminal electrodes T12 and T13, a corresponding current flows in the compensation coil C to generate a cancelling magnetic field in the reverse direction. This cancels the magnetic field to be detected. Then, a current output from the differential amplifier 81 is current-voltage converted, whereby the strength of the magnetic field to be detected can be detected. By such closed-loop control, it is possible to detect a magnetic field collected through the external magnetic bodies 30 and 40 with high accuracy.

FIGS. 9 and 10 are schematic perspective views for explaining the structure of the magnetism collecting module 60 as viewed from mutually different angles. FIG. 11 is a schematic exploded perspective view of the magnetism collecting module 60 in a state where the compensation coil C is removed.

As illustrated in FIGS. 9 to 11, the magnetism collecting module 60 includes the molded member 70, the external magnetic body 30 fixed to the molded member 70, the compensation coil C, and the connection pins P1 and P2. The molded member 70 is a single member including a bobbin 71, a retaining part 72, a leading end part 73, and a positioning parts 74 and 75. The bobbin 71 houses therein a narrow part 31 of the external magnetic body 30 and has the leading end part 73 at its leading end in the positive Z-direction. The leading end part 73 has a slit 73a extending in the X-direction. The retaining part 72 is positioned on the negative Z-direction side of the bobbin 71, houses therein a wide part 32 of the external magnetic body 30, and retains the connection pins P1 and P2 provided in their corresponding through holes 76. The XY cross section of the narrow part 31 of the external magnetic body 30 is smaller than that of the wide part 32 of the external magnetic body 30.

The connection pins P1 and P2 are each a terminal electrode made of a U-like metal material. The connection pin P1 has protruding parts P1a and P1b protruding in the positive Y-direction from the surface of the retaining part 72, and the connection pin P2 has protruding parts P2a and P2b protruding in the positive Y-direction from the surface of the retaining part 72. The protruding part P1a is a part connected with one end of the compensation coil C, and the protruding part P2a is a part connected with the other end of the compensation coil C. The protruding parts P1a and P2a are arranged in the X-direction and positioned on the negative Z-direction side of the bobbin 71. The protruding parts P1b and P2b are connected respectively with the terminal electrodes T21 and T22 illustrated in FIG. 8 each through a not-shown wiring.

As illustrated in FIG. 10, the XZ bottom surfaces of the bobbin 71 and retaining part 72 are partly opened, through which the external magnetic body 30 is exposed. The XZ bottom surface of the wide part 32 of the external magnetic body 30 protrudes in the negative Y-direction from the retaining part 72. Thus, when the magnetism collecting module 60 is mounted on the substrate 10, the wide part 32 of the external magnetic body 30 is fixed to the surface 11 of the substrate 10. On the other hand, the XZ bottom surface of the narrow part 31 of the external magnetic body 30 does not protrude from the bobbin 71. The XZ bottom surface of the bobbin 71 need not necessarily have the opening; however, forming the opening allows the external magnetic body 30 to be attached to the molded member 70 in the Y-direction.

The compensation coil C is wound around the bobbin 71 with the Z-direction as the winding axis direction. One end of the compensation coil C is connected to the protruding part P1a of the connection pin P1, and the other end thereof is connected to the protruding part P2a of the connection pin P2. The protruding parts P1a and P2a respectively have positioning parts 84 and 85 with locally reduced diameters. The one and the other ends of the compensation coil C are respectively wound around the positioning parts 84 and 85 and soldered thereto. As a result, the Y-direction positions of the one end and the other end of the compensation coil C connected respectively to the protruding parts P1a and P2a are fixed. The positioning parts 84 and 85 are located at positions closer to the leading ends of the respective connection pins P1 and P2 in the positive Y-direction than to the retaining part 72. Thus, the one end and the other end of the compensation coil C are also fixed at positions closer to the leading ends of the connection pins P1 and P2 in the positive Y-direction than to the retaining part 72.

The compensation coil C includes a solenoid part C0 wound around the bobbin 71, a lead-out part C1 positioned between one end of the solenoid part C0 and the connection pin P1, and a lead-out part C2 positioned between the other end of the solenoid part C0 and the connection pin P2. The solenoid part C0 functions as a coil and is wound around the bobbin 71 with the Z-direction as the winding axis direction. The solenoid part C0 is wound around the bobbin 71 such that the Z-direction position of the wire constituting the solenoid part C0 changes for every turn. That is, when the lead-out parts C1 and C2 are set as staring and end points, respectively, the position of the wire constituting the solenoid part C0 shifts in the positive Z-direction for every turn.

As described above, the compensation coil C is wound around the external magnetic body 30 not directly but through the bobbin 71, so that the compensation coil C and external magnetic body 30 do not contact each other, thereby preventing the compensation coil C and external magnetic body 30 from being damaged due to contact therebetween. The one end of the solenoid part C0 is positioned on the negative Z-direction side, and thus the wiring distance of the lead-out part C1 is short. On the other hand, the other end of the solenoid part C0 is positioned on the positive Z-direction side, and thus the wiring distance of the lead-out part C2 is long.

FIGS. 12 and 13 are schematic perspective views illustrating a state where the solenoid part C0 of the compensation coil C is removed from the magnetism collecting module 60 as viewed from mutually different angles.

As illustrated in FIGS. 12 and 13, the lead-out part C2 of the compensation coil C extends substantially straight in the Z-direction and is then folded back at the slit 73a. When the compensation coil C is to be wound around the bobbin 71, the wire constituting the compensation coil C is made to pass through the slit 73a at the leading end part 73 and is then wound plurality of turns to form the solenoid part C0. As a result, the lead-out part C2 is connected to the connection pin P2 not through the outside of the solenoid part C0 but through the inner diameter area of the solenoid part C0. Thus, most of the lead-out part C2 whose wiring distance is long is covered with the solenoid part C0, making the lead-out part C2 unlikely to act as an antenna. In addition, the lead-out part C2 is sandwiched between the bobbin 71 and the solenoid part C0 and is thus stabilized in position.

The molded member 70 has the positioning parts 74 and 75 positioned between the bobbin 71 and retaining part 72. The positioning part 74 is a protrusion for positioning the lead-out part C1 of the compensation coil C and protrudes in the positive X-direction. The positioning part 75 is a protrusion for positioning the lead-out part C2 of the compensation coil C and protrudes in the negative X-direction. The lead-out parts C1 and C2 extending in the Z-direction respectively pass through the negative Y-direction sides of the positioning parts 74 and 75 to be connected respectively to the connection pins P1 and P2. This restricts the movement of the lead-out parts C1 and C2 in the positive Y-direction.

When the one end and the other end of the compensation coil C are to be connected respectively to the connection pins P1 and P2, they are wound respectively around the protruding parts P1a and P2a, and then the leading ends of the protruding parts P1a and P2a are immersed in a solder bath 90 as illustrated in FIG. 14. Through this procedure, connection between the one and the other ends of the compensation coil C and the connection pins P1 and P2 is completed at a time. In immersing the leading ends of the protruding parts P1a and P2a in the solder bath, the lead-out parts C1 and C2 do not contact the solder bath 90 as a result of hanging down since the movement of the lead-out parts C1 and C2 of the compensation coil C in the positive Y-direction is restricted by the positioning parts 74 and 75 of the molded member 70.

As described above, in the present embodiment, the external magnetic body 30 and the connection pins P1 and P2 are fixed to the molded member 70, and then winding of the compensation coil C and connection between the connection pins P1 and P2 and the compensation coil C are carried out to produce the magnetism collecting module 60, followed by mounting of the produced magnetism collecting module 60 on the substrate 10, thus allowing the magnetic sensor module 1 to be produced efficiently. The lead-out part C2 of the compensation coil C included in the magnetism collecting module 60 passes through the inner diameter area of the solenoid part C0 to be connected to the connection pin P2, making the lead-out part C2 unlikely to act as an antenna, which can reduce the influence of disturbance noise.

FIG. 15 is a schematic perspective view illustrating the configuration of a magnetism collecting module 60B according to a comparative example. The magnetism collecting module 60B according to the comparative example differs from the magnetism collecting module 60 illustrated in FIG. 9 in that the lead-out part C2 of the compensation coil C passes not through the inner diameter area of the solenoid part C0 but through the outside of the solenoid part C0 in the radial direction to be connected to the connection pin P2. FIG. 16 is a graph illustrating the frequency characteristics of noise density, in which a reference symbol A denotes the characteristics of the magnetic sensor module 1 according to the present embodiment, and a reference symbol B denotes the characteristics of a magnetic sensor module that uses the magnetism collecting module 60B according to the comparative example in place of the magnetism collecting module 60. The graph of FIG. 16 reveals that the noise density in a low-frequency region of the magnetic sensor module 1 according to the present embodiment is lower than that of the magnetic sensor module using the magnetism collecting module 60B.

While the preferred embodiment of the present disclosure has been described, the present disclosure is not limited to the above embodiment, and various modifications may be made within the scope of the present disclosure, and all such modifications are included in the present disclosure.

For example, although both ends of the compensation coil C are connected respectively to the connection pins P1 and P2 in the above embodiment, it is not essential to use the connection pins P1 and P2 as terminal electrodes to be connected to the both ends of the compensation coil C.

### [Reference Signs List]

1 magnetic sensor module
2 lower case
3 upper case
10 substrate
11 surface of substrate
20 sensor chip
21 element formation surface
22 back surface of sensor chip
23-26 side surface of sensor chip
27, 28 insulating layer
30, 40 external magnetic body
30a, 40a area covered with external magnetic body
31 narrow part
32 wide part
41 bar-like part
42, 43 overhang part
50 auxiliary chip
60, 60B magnetism collecting module
70 molded member
71 bobbin
72 retaining part
73 leading end part
73a slit
74, 75 positioning part
76 through hole
81 differential amplifier
82 detection circuit
84, 85 positioning part
90 solder bath
100 magnetic sensor
C compensation coil
C0 solenoid part
C1, C2 lead-out part
G1-G4 magnetic gap
M1-M3, M11, M21, M31, M12, M22, M32 magnetic layer
P1, P2 connection pin
P1a, P1b, P2a, P2b protruding part
R1-R4 magnetosensitive element
T10, T30 terminal electrode group
T11-T14, T21, T22 terminal electrode

## Claims

1. A magnetic sensor comprising:
a magnetosensitive element;
an external magnetic body collecting a magnetic field to be detected in the magnetosensitive element; and
a compensation coil connected to first and second terminal electrodes,
wherein the compensation coil includes a solenoid part wound around the external magnetic body, a first lead-out part positioned between one end of the solenoid part and the first terminal electrode, and a second lead-out part positioned between other end of the solenoid part and the second terminal electrode,
wherein the one end of the solenoid part is positioned on one side of the external magnetic body in an axial direction,
wherein the other end of the solenoid part is positioned on other side of the external magnetic body in the axial direction,
wherein the first and second terminal electrodes are positioned on the one side in the axial direction, and
wherein the second lead-out part passes through an inner diameter area of the solenoid part so as to be connected to the second terminal electrode.

2. The magnetic sensor as claimed in claim 1, further comprising a molded member having a bobbin positioned between the external magnetic body and the solenoid part,
wherein the solenoid part is wound around the bobbin, and
wherein the second lead-out part is positioned between the bobbin and the solenoid part.

3. The magnetic sensor as claimed in claim 2,
wherein the first and second terminal electrodes are formed as first and second connection pins, respectively, and
wherein the molded member further includes a retaining part for retaining the first and connection second pins.

4. The magnetic sensor as claimed in claim 3,
wherein the first and second connection pins protrude in a predetermined direction perpendicular to the axial direction of the external magnetic body from the retaining part, and
wherein the first and second lead-out parts are fixed to a position closer to leading ends of the first and second connection pins than to the retaining part.

5. The magnetic sensor as claimed in claim 4, wherein each of the first and second connection pins has a first positioning part positioning a position of each of the first and second lead-out parts in the predetermined direction.

6. The magnetic sensor as claimed in claim 4 or 5, wherein the molded member has a second positioning part positioned between the bobbin and the retaining part and positioning the first and second lead-out parts in the predetermined direction.

7. The magnetic sensor as claimed in any one of claims 3 to 6,
wherein the external magnetic body, the compensation coil, and the first and second connection pins are fixed to the molded member to constitute a magnetism collecting module, and
wherein a sensor chip including the magnetosensitive element and the magnetism collecting module are mounted on a same plane of a substrate.

8. The magnetic sensor as claimed in claim 7,
wherein the external magnetic body has a wide part and a narrow part whose cross section perpendicular to the axial direction is smaller than that of the wide part,
wherein the bobbin houses therein the narrow part of the external magnetic body,
wherein the retaining part houses therein the wide part of the external magnetic body,
wherein an opening is formed in a bottom surface of each of the bobbin and retaining part that faces the substrate,
wherein the wide part of the external magnetic body protrudes from the opening of the retaining part,
wherein the narrow part of the external magnetic body does not protrude from the opening of the bobbin, and
wherein the wide part of the external magnetic body protruding from the opening of the retaining part is fixed to the substrate.
